# FASCICULE DE BREVET EUROPEEN

(11) **EP 0 815 281 B1**
(45) Date de publication et mention de la délivrance du brevet: **07.01.1999**
(21) Numéro de dépôt: 96908158.7
(22) Date de dépôt: 20.03.1996
(51) Int. Cl.: C23C 14/04, C23C 14/28, C23C 24/10

(54) **DISPOSITIF A MICROTETE PHOTO-IONIQUE**
VORRICHTUNG MIT MINIATURISIERTEM PHOTOIONISCHEM KOPF
PHOTOIONIC MICROHEAD DEVICE

(30) Priorité: 21.03.1995 FR 9503275
(43) Date de publication de la demande: 07.01.1998
(73) Titulaire: COMMISSARIAT A L'ENERGIE ATOMIQUE, 75015 Paris (FR)
(72) Inventeur: ELOY, Jean-François, Albert, F-33170 Gradignan (FR)
(74) Mandataire: Signore, Robert
(86) Numéro de dépôt international: FR9600417
(87) Numéro de publication internationale: WO9629444

(56) Documents cités:
- WO-A-95/07368
- US-A- 4 564 736
- US-A- 4 814 575

## Description

### Domaine technique

L'invention concerne un dispositif pour traiter la surface d'un matériau par ajout d'une matière sous forme de poudre.

Ce dispositif, qui consiste en un stylet à microtête photo-ionique, trouve des applications dans de nombreux domaines. L'invention peut s'appliquer, notamment, au domaine de la micro-électronique pour le dépôt localisé de couches spécifiques, la restauration ou l'annihilation de fonctions des composants d'un micro-circuit ou encore la réalisation de nouveaux types d'alliages pour connexions électriques. Elle peut s'appliquer aussi au domaine de la micro-mécanique pour des dépôts localisés de composés réfractaires améliorant la résistance à la corrosion, à l'abrasion ou par durcissement pour réduire un frottement. L'invention trouve également des applications dans le nettoyage et la restauration d'objets anciens et d'objets d'art nécessitant une microlocalisation de l'intervention ou pour des traitements automatiques localisés en milieux hostiles.

En particulier, l'invention trouve àes applications dans le domaine dentaire et, notamment, dans le àomaine de la chirurgie àentaire, pour des préparations et traitements indolores localisés des dents ou pour des adaptations de prothèses afin d'aboutir à une restauration des tissus et une amélioration de la résistance à la carie.

### Etat de la technique

Il est connu que la composition de la surface d'un matériau peut être modifiée en ajoutant de la matière sur cette surface.

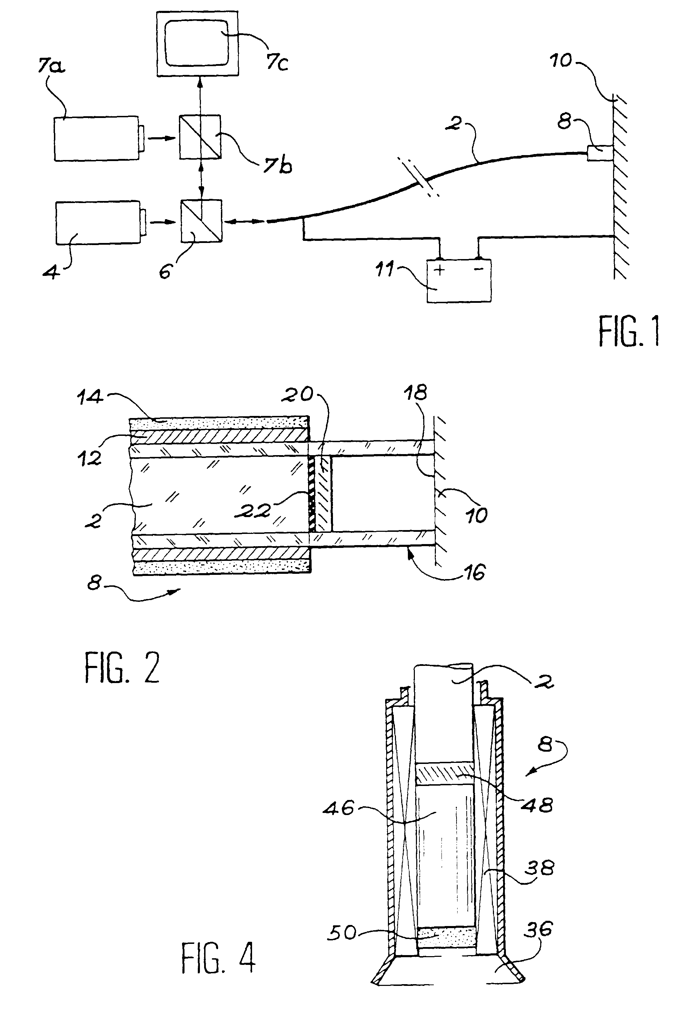

Le document FR-A-2 709 763 décrit un dispositif de traitement d'un matériau utilisant une tête photo-ionique miniaturisée comportant une couche de la matière à déposer. La figure 1 représente schématiquement ce dispositif de traitement d'un matériau qui comporte une fibre optique 2, un laser de puissance 4 apte à émettre un faisceau laser pulsé, des moyens 6 d'injection du faisceau laser dans l'une des deux extrémités de la fibre optique 2 et une tête photo-ionique miniaturisée 8 permettant de traiter la surface du matériau 10 ; cette tête photo-ionique 8 est montée sur la deuxième extrémité de la fibre optique.

Ce dispositif comporte, en outre, des moyens 11 pour établir, dans le dispositif lui-même, des différences de potentiel.

Selon un mode de réalisation de ce dispositif, ce dernier comporte en outre, un autre laser 7a apte à émettre en continu une lumière visible permettant l'observation de la zone à traiter, un moyen optique 7b assurant le couplage et l'injection du faisceau laser d'observation et des moyens d'observation 7c (tels qu'un écran vidéo) pour permettre la visualisation de la zone du matériau à traiter.

Sur la figure 2, on a représenté de façon plus détaillée la tête photo-ionique 8 de ce dispositif. On voit, sur cette figure 2, que la fibre optique 2 comprend une gaine électriquement conductrice 12 (par exemple une gaine métallique tressée) qui entoure la gaine optique de la fibre 2 sur toute la longueur de celle-ci, ainsi qu'une autre gaine électriquement isolante 14 qui entoure la gaine 12 et qui joue le rôle de gaine de protection.

La tête 8 comprend en outre une bague électriquement isolante 16 dont le diamètre extérieur est sensiblement égal au diamètre extérieur de la fibre optique 2 et qui est placée, d'un côté, contre la face plane de l'extrémité de cette fibre optique 2 tandis que l'autre côté de la bague 16 est destiné à être placé contre le matériau à traiter 10.

Plus précisément, la tête 8 est positionnée de façon à ce que la bague 16 entoure la zone 18 du matériau que l'on veut traiter.

Cette tête 8 comprend, de plus, une couche mince 20 réalisée dans la matière à projeter sur la zone 18. Cette couche mince 20 est placée dans l'espace délimité par la bague 16, contre la face plane de l'extrémité de la fibre optique 2 ; elle se trouve ainsi à distance de la zone à traiter 18.

Sur cette figure 2, est également représentée une couche intermédiaire 22 permettant de réduire le saut d'indice optique entre la matériau constitutif de la fibre optique 2 et le matériau constitutif de la couche mince 20.

Les moyens 11 de polarisation fournissent une polarisation au matériau 10 de façon à créer, dans la bague 16, un champ électrique capable d'accélérer des ions formés à partir de la couche mince 20 afin d'implanter ces ions dans la zone 18 du matériau 10.

Plus précisément, l'implantation des ions dans cette zone 18 est réalisée de la façon suivante :
- le laser 4 est àéclenché ; il émet alors une impulsion lumineuse de puissance qui est injectée dans la fibre optique 2 et s'y propage jusqu'à la tête photo-ionique 8 ;
- cette impulsion de puissance atteint la couche mince 20 et provoque l'évaporation de celle-ci de manière explosive ;
- un plasma se forme alors dans l'espace 19 délimité par la bague 16 et les ions (positifs) de ce plasma sont accélérés en direction de la zone 18 grâce au champ électrique établi comme indiqué précédemment ; les ions sont alors implantés dans cette zone 18, tandis que les électrons du plasma sont accélérés en sens contraire vers la fibre optique 2.

La bague 16 sert donc à confiner le plasma et l'onde explosive (ou onde de choc) engendrée lors de la formation de celui-ci.

Ce dispositif présente donc l'inconvénient de ne pouvoir être utilisé avec une matière sous forme de poudre. En effet, la matière est introduite dans le dispositif sous la forme d'une couche mince (20) qui est réalisée par un procédé de dépôt sous vide.

En outre, puisque la tête photo-ionique inclue la couche mince de matière à déposer, elle ne peut être réutilisée qu'après une opération de rechargement, c'est-à-dire de redépôt de matière afin de former une autre couche mince sur la face de sortie de la fibre optique, ce qui rend le temps de manipulation relativement long.

Pour projeter un composé chimique en poudre sur la surface d'un matériau, l'homme du métier peut utiliser un système de projection de poudre décrit dans Clauer A. H., Fairand B. P., Application cf lasers in material processing, Metzbower E. A. edit. American Society for Metals, Metal Park, Ohio, 1979.

Ce système de projection comporte une buse à air comprimé ou à gaz chimiquement inactif ou actif. A cette buse, il peut être associé des moyens de combustion de gaz pour que le composé soit projeté sous la forme d'un plasma afin d'atteindre la fusion de la poudre avant qu'elle-même n'atteigne la surface à traiter. Dans le procèdé mis en oeuvre par ce système, la formation d'une couche d'alliage de surface formée par la projection d'une poudre nécessite la combustion d'un gaz en continu. Or, cette projection sous forme de plasma se fait à haute température, ce qui rend le système inutilisable sur certains matériaux, en particulier, sur les tissus biologiques qui ne supportent pas un fort gradient thermique.

En outre, quel que soit le procédé utilisé pour traiter la surface d'un matériau par ajout d'une matière sous forme de poudre, il est généralement nécessaire d'effectuer une préparation de cette surface. Or, cette préparation est délicate et difficile à réaliser, surtout lorsque la matière est une poudre pulvérulente impropre à être compactée.

### Exposé de l'invention

L'invention a justement pour but de remédier aux inconvénients des dispositifs connus, décrits précédemment. A cette fin, elle propose un dispositif à micro-tête photo-ionique permettant d'effectuer des traitements sur la surface d'un matériau par ajout d'une matière sous forme de poudre.

De façon plus précise, l'invention concerne un dispositif de traitement d'un matériau par dépôt de matière comportant :
- au moins une fibre optique ;
- une source de lumière pouvant engendrer une lumière pulsée ;
- des moyens d'injection de la lumière dans une première extrémité de la fibre optique ;
- une tête photo-ionique miniaturisée fixée sur la seconde extrémité de la fibre optique et assurant la diffusion de l'onde transmise par la fibre optique ; et
- une bague de confinement disposée entre la tête photo-ionique et le matériau à traiter.

Ce dispositif comporte en outre une enveloppe entourant la tête photo-ionique, ainsi qu'une partie au moins de la fibre optique et formant une chambre de dispersion dans laquelle est introduite la matière à déposer sur le matériau.

La matière étant une poudre, l'enveloppe comporte deux réservoirs concentriques dont l'un est apte à contenir de la poudre et l'autre est apte à contenir du gaz.

Ces réservoirs ont une ouverture débouchant dans la chambre, de sorte que la poudre et le gaz puissent s'introduire dans la chambre.

Avantageusement, le dispositif de l'invention comporte un système d'ailettes placé au niveau de l'ouverture des réservoirs vers la chambre pour assurer une dispersion de la poudre dans le gaz et créer une poudre dispersée.

Selon l'invention, la tête photo-ionique comporte un diffuseur orienté vers le matériau à traiter et qui assure, d'une part, la diffusion de l'onde propagée par la fibre optique dans la poudre dispersée de façon à créer une onde de choc et, d'autre part, l'extraction de la poudre dispersée hors du dispositif.

De façon avantageuse, la bague de confinement comporte :
- une buse principale percée en son centre et fixée sur l'enveloppe pour assurer la propagation de l'onde de choc ; et
- une buse secondaire percée en son centre et disposée à l'intérieur de la buse principale pour renvoyer, vers le diffuseur, la poudre dispersée provenant de la chambre.

La fibre optique est revêtue d'une gaine électriquement conductrice et la buse principale est recouverte, sur sa paroi intérieure, d'une couche de matériau électriquement conducteur de façon à assurer une différence de potentiel entre ladite buse et la gaine de la fibre optique.

Selon un mode de réalisation de l'invention, le dispositif comporte des moyens de chauffage disposés dans le réservoir de poudre pour préchauffer ladite poudre.

Selon un mode de réalisation préféré de l'invention, la tête photo-ionique comporte une micropuce laser placée entre la seconde extrémité de la fibre cptique et le diffuseur.

### Brève description des figures

- La figure 1, déjà décrite, représente schématiquement le dispositif de l'art antérieur ;
- la figure 2, déjà décrite, représente schématiquement la tête photo-ionique miniaturisée du dispositif de l'art antérieur ;
- la figure 3 représente schématiquement le stylet de projection de poudre conforme à l'invention ; et
- la figure 4 représente un mode de réalisation de la microtête photo-ionique conforme à l'invention.

### Description détaillée de modes de réalisation de l'invention

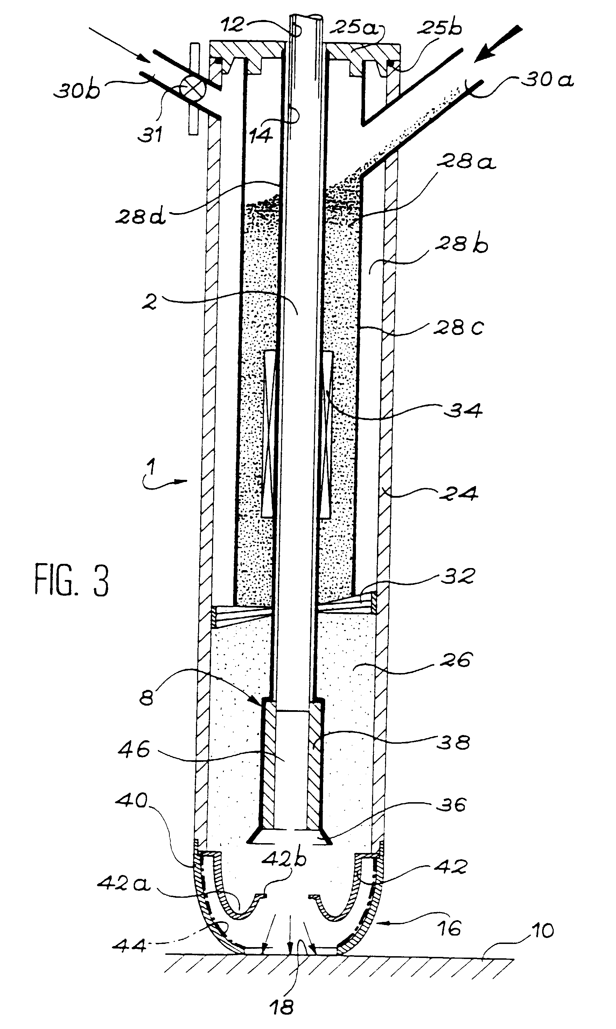

Sur la figure 3, on a représenté le stylet à microtête photo-ionique conforme à l'invention. Sur cette figure 3, ainsi que sur la figure 4 qui sera décrite par la suite, les éléments du dispositif de l'invention qui sont identiques à ceux du dispositif de l'art antérieur montré sur les figures 1 et 2, porteront des références identiques.

En outre, par mesure de simplification, il n'a pas été représenté sur les figures 3 et 4, les moyens du dispositif autre que le stylet (par exemple le laser pulsé 4, les moyens d'introduction des faisceaux laser dans la fibre optique 2, les moyens de polarisation 11, etc.) puisque ces moyens sont montrés sur la figure 1 et qu'ils sont identiques pour le dispositif antérieur et pour le dispositif de l'invention.

Sur la figure 3, on a donc représenté le stylet à microtête photo-ionique conforme à l'invention.

Ce stylet 1 comporte une fibre optique 2 entourée d'une première gaine 12 électriquement conductrice et d'une seconde gaine 14 en matériau isolant. Comme dans le dispositif de la figure 1, cette fibre optique 2 est reliée par une de ses extrémités aux moyens pour introduire le faisceau laser pulsé dans ladite fibre optique 2 ; et sur sa seconde extrémité est montée la tête photo-ionique 8 miniaturisée. Cette microtête 8 a pour rôle de propager l'impulsion de puissance issue du laser jusqu'à la matière à déposer (poudre) et de diffuser cette impulsion de façon à ioniser la manière que l'on souhaite déposer sur la zone 18 du matériau 10. Entre la microtête 8 et le matériau 10, est placée la bague 16 assurant le confinement de cette matière. Cette bague 16 est apte à confiner un plasma susceptible de se former grâce à la lumière pulsée, dans l'espace délimité par cette bague, à partir de la poudre qui s'y trouve. Cette bague 16 sera décrite plus en détail dans la suite de la description.

La microtête 8 et une partie de la fibre 2 sont entourées par une enveloppe 24 formant, dans une partie de l'enveloppe, une chambre de dispersion 26. A l'intérieur de cette enveloppe 24, est également réalisé un double réservoir 28a/28b. Plus précisément, ce double réservoir est réalisé à partir d'une première paroi 28d entourant la fibre optique 2 et d'une seconde paroi 28c concentrique à la première paroi 28d et à l'enveloppe 24 et. la seconde paroi 28c forme, entre la première paroi 28d et elle-même, un réservoir de poudre, et entre elle-même et l'enveloppe 24, un réservoir de gaz 28b. Ce gaz peut être un gaz inerte tel que l'azote ou l'oxygène ou bien un gaz léger du type hélium.

Une conduite 30b débouche dans le réservoir de gaz 28b de façon à y permettre l'introduction du gaz. Cette conduite 30b est munie en outre d'une gâchette 31 permettant l'ouverture ou la fermeture du conduit, ce qui permet une introduction non continue du gaz dans le stylet 1.

De façon similaire, une conduite 30a débouche dans le réservoir 28a et permet l'introduction de poudre dans ledit réservoir.

Le conduit d'introduction de la poudre dans le réservoir de poudre 28a peut également comporter une gâchette, non représentée sur la figure par mesure de simplification, mais sensiblement identique à la gâchette 31 du conduit d'introduction de gaz 30b. Cette gâchette permettrait, comme pour la gâchette du gaz, de contrôler l'introduction de la poudre, et notamment la quantité de poudre introduite.

Ces réservoirs de poudre 28a et de gaz 28b sont fermés à l'une de leurs extrémités par un couvercle 25a muni d'un joint torique 25b. L'autre extrémité de ces réservoirs 28a et 28b débouche dans la chambre de dispersion 26. A cette extrémité, un système d'ailettes 32 assure la dispersion de la poudre issue du réservoir de poudre 28a et entraînée par le flux du gaz d'injection provenant du réservoir 28b. La poudre alors introduite dans la chambre de dispersion est mélangée au gaz et est appelée "poudre dispersée". Au préalable, la poudre a pu être préchauffée, lorsqu'elle était dans son réservoir 28a par effet Joule ou par micro-ondes au moyen d'un manchon 34 placé dans le réservoir de poudre 28a, autour de la fibre optique 2. Ce manchon a pour rôle de porter le composé en poudre à une température de 30 à 80° selon les besoins, ce qui permet de dessécher ou bien de déshydrater ce composé en poudre ou encore d'augmenter, si cela est nécessaire, son activité chimique au moment du dépôt.

La microtête photo-ionique 8 comporte un diffuseur 36, ainsi qu'un support de tête permettant de maintenir l'ensemble de la micro-tête avec la fibre optique 2.

Ce diffuseur 36 a pour rôle de diffuser l'impulsion de puissance transmise par la fibre optique dans la poudre dispersée ; il assure en outre l'évacuation de la poudre hors du stylet 1.

La bague de confinement 16 est montée sur l'enveloppe 24, à l'extrémité de la microtête 8. Plus précisément, cette bague de confinement 16 est montée sur l'enveloppe 24 de façon à être amovible. Elle peut constituer, par exemple, un système vis/écrou avec l'extrémité de ladite enveloppe 24.

Cette bague de confinement 16 comporte une buse principale 40 et une buse secondaire 42. La buse secondaire 42 est du type buse-chicane, c'est-à-dire qu'elle est percée en son centre et ajourée de minuscules petits trous destinés à canaliser la poudre dispersée. En outre, cette buse secondaire est incurvée de façon à former une cuvette cylindrique 42a avec un rebord central 42b. La forme spécifique de cette buse 42 a pour effet de renvoyer le nuage de poudre dispersée provenant de ia chambre de dispersion 26, sous forme de multijets de poudre, vers le diffuseur 36, c'est-à-dire vers l'endroit d'où sort l'impulsion de puissance (c'est-à-dire l'onde de choc).

La buse principale 40 est également percée en son centre de façon à permettre la sortie de la poudre à projeter hors du stylet, vers la zone 18 du matériau à traiter. En effet, le rayonnement laser transmis par la fibre optique 2 sort de la microtête photo-ionique 8 sous la forme d'une onde de choc qui induit un processus de volatilisation par thermochoc de la poudre située à proximité de la sortie de la microtête 8, c'est-à-dire du diffuseur 36. Cette poudre, appelée "poudre volatilisée" est ensuite dirigée par le diffuseur 36 et les buses 40 et 42 vers la sortie du stylet 1, c'est-à-dire vers le matériau 10. Le rayonnement laser qui induit le processus de volatilisation par thermochoc permet, d'une part, de localiser le dépôt d'énergie au niveau de la sortie du dispositif optique, c'est-à-dire de la microtête 8 et permet, d'autre part, de limiter l'élévation de température à celle de la matière projetée. Ce procédé n'engendre donc aucun dégagement de chaleur supérieur à la température apportée par le manchon 34 à la poudre.

La buse principale 40 assure un confinement de la poudre volatilisée, ce qui permet à l'onde de choc issue de la microtête 8 de se propager jusqu'à la sortie du stylet 1, c'est-à-dire jusqu'au matériau 10. En outre, cette buse 40 est recouverte sur sa paroi intérieure d'une couche 44 de matériau électriquement conducteur. Ce revêtement 44 peut être porté à un certain potentiel électrique, grâce, par exemple, au moyen de polarisation 11, montré sur la figure 1. De préférence, ce revêtement est porté à un potentiel de référence, tel que le potentiel électrique de la terre, qui permet de créer entre la gaine 12 de la fibre optique 2, et ladite buse principale 40, un certain champ électrique. Ce champ électrique assure l'accélération des ions formés à partir de l'onde de choc et de la poudre dispersée de façon à implanter ces ions dans la zone 18 du matériau 10 à traiter. Ainsi, la seule différence entre le dispositif de l'art antérieur montré sur la figure 1 et le dispositif de l'invention, du point de vue des connexions, réside dans le fait que les moyens de polarisation il sont connectés, non pas sur le matériau 10, comme dans l'art antérieur, mais sur le revêtement 44 de la buse principale 40.

La buse principale 40 a de plus pour rôle de permettre la déviation d'une partie du jet de gaz arrivant périphériquement au jet de gaz chargé de poudre, de manière, d'une part, à faciliter l'inversion de la direction de 180° du jet de poudre et, d'autre part, à plaquer la poudre sur le diffuseur 36.

Selon le mode de réalisation préféré de l'invention, le laser émet des faisceaux pulsés, c'est-à-dire discontinus, ce qui permet de projeter la poudre de façon discontinue, tout en ayant une introduction continue de la poudre dans la chambre de dispersion. Ce phénomène permet de réduire de façon importante le temps de manipulation, dans le cas notamment, où il est nécessaire de déposer des épaisseurs importantes sur la surface des matériaux.

Plus précisément, le faisceau laser transmis par la fibre optique 2 pour être introduit dans la microtête 8 est pulsé à haute cadence, de manière à permettre de façon successive et à intervalles réguliers :
- le dépôt d'une fine couche de poudre par jet de poudre injecté par le gaz et pulvérisé par le système d'ailettes 32 sur le diffuseur 36 ; et
- la volatilisation de cette fine couche de poudre pour l'implanter sur la surface du matériau à traiter.

Sur la figure 4, on a représenté de façon plus détaillée, le mode de réalisation préféré de la microtête photo-ionique. Sur cette figure 4, on voit, comme sur la figure 3, la fibre optique 2 se terminant dans la microtête 8. Comme sur la figure 3, la microtête 8 comporte le diffuseur 36 et le support de tête 38. Il comporte, en outre, une micropuce 46 qui peut être, par exemple, une micropuce laser. Cette micropuce 46 a pour role d'assurer la transformation du flux de niveau bas provenant de la fibre optique en un flux de haut niveau nécessaire pour que soit produite une onde de choc. Cette micropuce 46 permet d'utiliser, pour le dispositif, une fibre optique de type tout à fait ordinaire, c'est-à-dire bon marché, ce qui a l'avantage de rendre l'ensemble de la tête d'un coût tout à fait intéressant, notamment pour les applications à la chirurgie dentaire puisque, pour une telle application, il est nécessaire d'avoir une technologie relativement bon marché et souple d'utilisation.

Bien sûr, cette micropuce 46 n'est pas nécessaire au fonctionnement du dispositif (voir mode de réalisation de la figure 3) . Dans ce cas, il est possible d'utiliser simplement une fibre optique ; mais cette fibre optique doit être d'un type tout à fait adapté à l'application envisagée ; elle est donc, généralement, d'un coût relativement élevé.

Sur le mode de réalisation montré sur la figure 4, on a en plus déposé une couche anti-reflet 48 entre la face de sortie de la fibre optique 2 et la micropuce 46 pour permettre une meilleure adaptation des flux de lumière provenant de la fibre optique et améliorer ainsi le rôle du laser. Cette couche anti-reflet permet donc que les flux de lumière ne se réfléchissent sur l'entrée de la micropuce 46.

Selon ce mode de réalisation préféré de l'invention, la microtête 8 comporte en outre une couche de matériau absorbant saturable permettant le déclenchement optique de la cavité laser afin d'atteindre des densités de flux laser délivrées élevées, nécessaires à la création de l'effet de choc et à la volatilisation de la poudre.

La microtête 8 permet en outre, lorsqu'il n'y a pas d'injection de gaz, ni d'apport de poudre, de réaliser des fonctions autres que celles décrites précédemment. Elle permet par exemple, de préparer préalablement la surface du matériau 10 en mettant en oeuvre par exemple un procédé de nettoyage par désorption laser ou par photoablation au laser ou encore par thermochoc direct induit par le laser impactant sur la surface du matériau 10.

Le stylet 1 décrit précédemment présente l'avantage d'être facile à manier. Il permet ainsi de réaliser, sur une grande variété de surface d'objets de petites dimensions et souvent d'accès difficile, des traitements microlocalisés, tels que de la désinfection bactérienne, des plaquages, des colmatages de canaux, cavités ou fissures, des durcissement et vitrification superficiels et surtout une fabrication d'amalgames et d'alliages nouveaux.

## Revendications

1. Dispositif de traitement d'un matériau par dépôt de matière comportant :
- au moins une fibre optique (2) ;
- une source de lumière (4) pouvant engendrer une lumière pulsée ;
- des moyens d'injection (6) de la lumière dans une première extrémité de la fibre optique ;
- une tête photo-ionique miniaturisée (8) fixée sur une seconde extrémité de la fibre optique et assurant la diffusion de la lumière propagée par la fibre optique vers la matière à déposer ; et
- une bague de confinement (16) disposée entre la tête photo-ionique et le matériau à traiter,
caractérisé en ce qu'il comporte en outre une enveloppe (24) entourant la tête photo-ionique ainsi qu'une partie au moins de la fibre optique et formant une chambre de dispersion (26) dans laquelle se trouve de la matière à déposer sur le matériau (10).

2. Dispositif selon la revendication 1, caractérisé en ce que, la matière à déposer étant une poudre, l'enveloppe comporte deux réservoirs (28a, 28b) concentriques dont l'un est apte à contenir de la poudre et l'autre est apte à contenir du gaz.

3. Dispositif selon la revendication 2, caractérisé en ce que les réservoirs ont chacun une ouverture débouchant dans la chambre de dispersion, la poudre et le gaz pouvant alors être introduits dans la chambre.

4. Dispositif selon la revendication 3, caractérisé en ce qu'il comporte un système d'ailettes placé au niveau de l'ouverture des réservoirs vers la chambre de dispersion pour assurer une dispersion de la poudre dans le gaz et réaliser une poudre dispersée.

## Patentansprüche

1. Vorrichtung zur Bearbeitung eines Materials durch Aufbringen von Werkstoff, umfassend:
- wenigstens eine optische Faser (2);
- eine Lichtquelle (4), die ein gepulstes Licht erzeugen kann;
- Einleiteinrichtungen (6) des Lichts in ein erstes Ende der optischen Faser;
- einen miniaturisierten photoionischen Kopf (8), festgemacht an einem zweiten Ende der optischen Faser, der die Diffusion des sich durch die Faser fortpflanzenden bzw. ausbreitenden Lichts auf den aufzubringenden Werkstoff sicherstellt; und
- einen Einschließring (16), angeordnet zwischen dem photoionischen Kopf und dem zu behandelnden Material,
**dadurch gekennzeichnet,**
daß sie außerdem eine Hülle (24) umfaßt, die den photoionischen Kopf sowie wenigstens einen Teil der optischen Faser umgibt und eine Streuungskammer (26) bildet, in der sich der auf das Material (10) aufzubringende Werkstoff befindet.

2. Vorrichtung nach Anspruch 1, dadurch gekennzeichnet, daß der aufzubringende Werkstoff ein Pulver ist und die Hülle zwei konzentrische Speicher (28a, 28b) umfaßt, von denen der eine zur Aufnahme des Pulvers bestimmt ist und der andere zur Aufnahme von Gas.

3. Vorrichtung nach Anspruch 2, dadurch gekennzeichnet, daß jeder Speicher eine in die Streuungskammer mündende Öffnung hat, durch die dann das Pulver und das Gas in die Kammer eingespeist werden können.

4. Vorrichtung nach Anspruch 3, dadurch gekennzeichnet, daß sie ein System von Flügeln umfaßt, angebracht in Höhe der Öffnung der Speicher zur Zerstreuungskammer, um eine Zerstreuung des Pulvers in dem Gas zu gewährleisten und feinst verteiltes Pulver zu erhalten.

## Claims

1. Device for the treatment of a material by depositing a substance comprising:
- at least one optical fibre (2),
- a light source (4) able to produce a pulsed light,
- means (6) for injecting light into a first end of the optical fibre,
- a miniaturized photoionic head (8) fixed to a second end of the optical fibre and ensuring the diffusion of light propagated by the optical fibre towards the substance to be deposited and
- a confinement ring (16) located between the photoionic head and the material to be treated,
characterized in that it also has an envelope (24) surrounding the photoionic head and at least part of the optical fibre and forming a dispersion chamber (26) in which is located the substance to be deposited on the material (10).

2. Device according to claim 1, characterized in that, with the substance to be deposited being a powder, the envelope has two concentric reservoirs (28a, 28b), one being for the powder and the other for the gas.

3. Device according to claim 2, characterized in that each of the reservoirs has an opening issuing into the dispersion chamber and the powder and gas can then be introduced into said chamber.

4. Device according to claim 3, characterized in that it has a fin system level with the opening of the reservoirs towards the dispersion chamber in order to ensure a dispersion of the powder in the gas and obtain a dispersed powder.
